Europäisches Patentamt

European Patent Office

Office européen des brevets

(11) Veröffentlichungsnummer: **0 326 812**

**A1**

(12) **EUROPÄISCHE PATENTANMELDUNG**

(21) Anmeldenummer: 89100281.8

(22) Anmeldetag: 09.01.89

(51) Int. Cl.⁴: **H02B 1/12 , H05K 5/06**

(30) Priorität: 01.02.88 DE 8801177 U

(43) Veröffentlichungstag der Anmeldung:
09.08.89 Patentblatt 89/32

(84) Benannte Vertragsstaaten:
AT CH DE ES FR GB LI

(71) Anmelder: Siemens Aktiengesellschaft Berlin
und München
Wittelsbacherplatz 2
D-8000 München 2(DE)

(72) Erfinder: Fricke, Klaus, Dipl.-Ing.
Uhlandstrasse 8
D-3340 Wolfenbüttel(DE)

(54) Druckausgleichsvorrichtung.

(57) Bei einem überflutungssicheren Gehäuse (1),
das beispielsweise im Eisenbahnsicherungswesen
Verwendung findet, wird eine Druckausgleichsvorrichtung vorgesehen. Diese hat die Aufgabe, unerwünschte Druckdifferenzen auf Grund von Temperaturwechseln auszugleichen, ohne daß Spritzwasser
oder Staub in das Gehäuse (1) eindringen kann.
Dies soll mit einfachen konstruktiven Maßnahmen
unter Anwendung handelsüblicher Bauteile erfolgen.
Für eine Filterscheibe (4) aus Sinter-Kinststoff ist ein
Tragelement (2) vorgesehen, in welches die Filterscheibe (4) mit Hilfe einer Druckschraube (6) einen
Dichtring (3) preßbar ist.

EP 0 326 812 A1

Fig. 1

## Druckausgleichsvorrichtung

Die Erfindung bezieht sich auf eine Druckausgleichsvorrichtung für ein überflutungssicheres Gehäuse zum Schutz elektrischer Einrichtungen, mit mindestens einer Öffnung, die unter Verwendung eines auf einem Dichtring aufliegenden Filters aus SinterKunststoff spritzwasser- und staubdicht verschließbar ist.

Besonders Signalschalteinrichtungen im rauhen Eisenbahnbetrieb werden zum Schutz gegen Feuchtigkeit, Verschmutzung und Sonneneinstrahlung von einem entsprechenden Gehäuse umgeben. Bei der Konstruktion derartiger Gehäuse wird besonderer Wert darauf gelegt, daß unter Zugrundelegung der verschiedensten Umwelteinflüsse der Wasserdampfgehalt der Luft im Gehäuse vorgegebene Werte nicht überschreitet. Dies kann beispielsweise dadurch erreicht werden, daß eine dosierte Menge eines Trockenmittels im Gehäuse bevorratet wird. Durch diese Maßhanme sind jedoch die Gehäuse nicht wartungsfrei, da das Trockenmittel von Zeit zu Zeit erneuert werden muß.

Besondere Probleme sind bei druckdichten, überflutungssicheren Gehäusen zu erwarten, wenn diese durch Witterungseinflüsse oder im normalen Betrieb vom warmen Zustand in den kalten wechseln und sich dabei im Gehäuse ein Unterdruck ausbilden kann. In dem Fall reicht eine noch so kleine Leckstelle aus, beispielsweise eine beschädigte Kabeldurchführung oder eine unsaubere Dichtung zwischen zwei Gehäuseteilen, durch die dann Feuchtigkeit in das Gehäuse gesaugt werden kann.

Bei einem bekannten Gehäuse für Signalschalteinrichtungen (DE-GM 71 36 203) wird durch eine technische Maßnahme dafür gesorgt, daß sich Druckdifferenzen zur Atmosphäre gar nicht erst ausbilden können. Zu dem Zweck wird zum spritzwasser- und staubdichten Verschließen der Öffnungen des Gehäuses ein Filterring aus Sinter-Kunststoff mit an die größte vorgesehene Öffnung angepaßtem Durchmesser und mit an eine Spange mit kreisrundem, isolierendem Kopf angepaßtem Innendurchmesser vorgesehen. Der Filterring wird durch die Spange mit mindestens zwei durch die Öffnungen des Gehäuses greifenden Hakenstiften befestigt. Dabei fassen die Haken hinter den Gehäuseboden und drücken den Filterring gegen die Vorspannung eines zwischen dem Filterring und dem Gehäuseboden umlaufenden Dichtringes fest auf den Boden.
Diese Maßnahme hat sich vom Grundsatz her durchaus bewährt; sie ist jedoch mechanisch recht aufwendig und birgt im Hinblick auf die Anforderungen der Eisenbahnsicherungstechnik unzulässige mechanische Unsicherheiten im Hinblick auf eine langfristige ordnungsgerechte Arbeitsweise.

Der Erfindung liegt somit die Aufgabe zugrunde, eine Druckausgleichsvorrichtung der eingangs genannten Art dahingehend weiterzubilden, daß die unerwünschten Druckdifferenzen unter Verwendung einer einfachen mechanischen Konstruktion mit handelsüblichen Bauteilen vermieden werden.
Diese Aufgabe wird gemäß der Erfindung dadurch gelöst, daß ein Tragelement für eine Filterscheibe ausgebildet ist, die durch eine Druckschraube auf den Dichtring preßbar ist. Dabei kann in vorteilhafter Weise eine Gehäusenabe als Tragelement ausgebildet sein. Eine andere vorteilhafte Ausführungsform der Erfindung sieht vor, daß ein in dia Gehäuseöffnung eingesetzter Zwischenstutzen als Tragelement dient.

Zwei Ausführungsbeispiele der Erfindung werden nachfolgend näher erläutert.

Es zeigen

Figur 1 den Ausschnitt eines Gehäuses mit einer Druckausgleichsvorrichtung und

Figur 2 eine Druckausgleichsvorrichtung in Verbindung mit einem Zwischenstutzen.

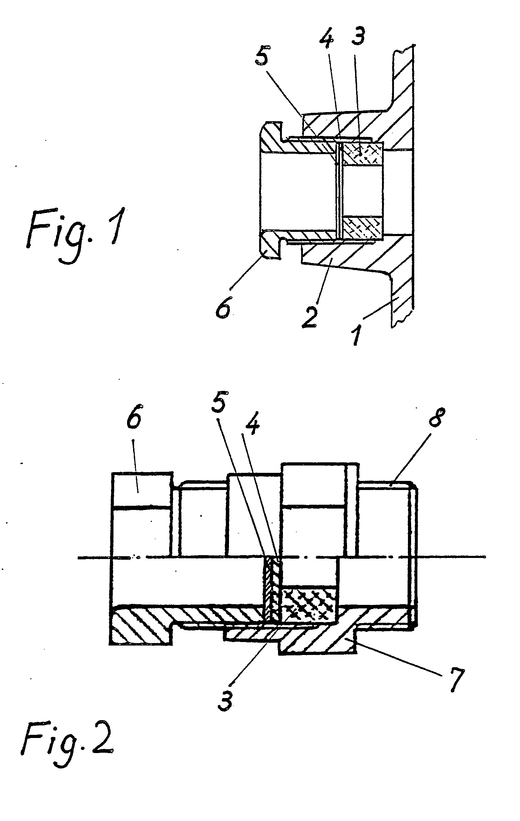

Figur 1 zeigt den Ausschnitt eines Gehäuses 1 mit einer Gehäusenabe 2 als Schnittbild. Die Gehäusenabe 2, die beispielsweise mehrfach zum Einführen von Kabeln in das Gehäuse 1 vorgesehen ist, dient im vorliegenden Falle als Tragelement für eine Druckausgleichsvorrichtung. Diese hat einerseits die Aufgabe, Druckdifferenzen zur Atmosphäre infolge von Witterungseinflüssen oder betriebsmäßigen Temperaturschwankungen zu vermeiden. Andererseits soll Luftfeuchtigkeit, die bei Montagearbeiten in das Gehäuse eingetreten sein kann, im Laufe der Zeit beispielsweise aufgrund von Eigenerwärmung an die Umwelt wieder abgegeben werden. Das Gehäuse 1 soll durch die Druckausgleichsvorrichtung auch überflutungssicher sein. Zu dem Zweck ist in der Gehäusenabe 2 ein Dichtring 3 vorgesehen, auf welchem eine Filterscheibe 4 aus Sinter-Kunststoff liegt. Diese Filterscheibe 4 kann beispielsweise aus einer feinporösen PTFE-Folie bestehen. Eine derartige Filterscheibe stellt für das Gehäuse 1 ein Belüftungselement dar mit hoher Luftdurchlässigkeit, das jedoch kein flüssiges Wasser hindurchtreten läßt. An den Poren derartiger Stoffe (Teflon) tritt eine sogenannte kapillare Depression auf. Hierdurch überspannen etwaige Wassertropfen die vorhandenen Kapillaren in der PTFE-Folie, so daß Wassertropfen nicht eindringen können. Aufgrund der hohen Oberflächenspannung des Wassers tritt dieses selbst bei einem etwaigen geringen Unterdruck im Gehäuse 1 nicht in dieses ein. Da Filterscheiben aus Sinter-Kunststoff eine sehr hohe Zahl von Poren aufweisen, gibt es bei vorhandenen Wassertröpfchen immer ausreichend viele Poren, die trotzdem nicht mit Wasser bedeckt sind, und über die ein gewünschter Luftaustausch zwischen dem Gehäuseinneren und der Umwelt erfolgen kann.

Zum mechanischen Schutz der Filterscheibe 4 ist zusätzlich ein Drahtsieb 5 vorgesehen. Als Abschluß der Gehäusenabe 2 dient eine handelsübliche, und damit preiswerte Druckschraube 6, die als billiges Massenprodukt kostengünstig zur Verfügung steht.

Beim Ausführungsbeispiel nach Figur 2 sind alle diejenigen Bauteile, die im Zusammenhang mit dem Ausführungsbeispiel nach Figur 1 bereits näher erläutert wurden, mit denselben Bezugszeichen versehen. Als Tragelement für eine Druckausgleichsvorrichtung dient bei dieser Ausführungsform ein Zwischenstutzen 7, der mit einem Außengewinde 8 versehen ist und in eine mit einem entsprechenden Gewinde versehene Öffnung eines nicht weiter dargestellten Gehäuses eingeschraubt werden kann. Der Zwischenstutzen 7 kann aber auch in eine Durchgangsbohrung des Gehäuses eingesetzt und mit einer Mutter befestigt werden. Die Anwendung des Zwischenstutzens 7, der ebenfalls als billiges Massenprodukt preisgünstig angeboten wird, ist in bevorzugter Weise immer dann gegeben, wenn bei einem Gehäuse keine Gehäusenabe mehr zur Verfügung steht und eine Nachrüstung mit einer Druckausgleichsvorrichtung gefordert wird.

## Ansprüche

1. Druckausgleichsvorrichtung für ein überflutungssicheres Gehäuse (1) zum Schutz elektrischer Einrichtungen, mit mindestens einer Öffnung, die unter Verwendung eines auf einem Dichtring (3) aufliegenden Filters aus Sinter-Kunststoff spritzwasser-und staubdicht verschließbar, **dadurch gekennzeichnet**, daß ein Tragelement (2, 7) für eine Filterscheibe (4) ausgebildet ist, die durch eine Druckschraube (6) auf den Dichtring (3) preßbar ist.

2. Druckausgleichsvorrichtung nach Anspruch 1, **dadurch gekennzeichnet,** daß eine Gehäusenabe (2) als Tragelement ausgebildet ist.

3. Druckausgleichsvorrichtung nach Anspruch 1, **dadurch gekennzeichnet,** daß ein in die Gehäuseöffnung eingesetzter Zwischenstutzen (7) als Tragelement dient.

Fig. 1

Fig. 2

Europäisches
Patentamt

**EUROPÄISCHER RECHERCHENBERICHT**

Nummer der Anmeldung

EP 89 10 0281

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4594082 (R.CATHERWOOD) <br> * Spalte 3, Zeile 51 - Spalte 4, Zeile 24 * <br> * Spalte 5, Zeile 9 - Zeile 13; Figuren 3, 7, 10 * <br> --- | 1, 2 | H02B1/12 <br> H05K5/06 |
| Y,D | DE-U-7136203 (SIEMENS AG) <br> * Seite 3, Zeile 15 - Seite 5, Zeile 12; Figuren 3, 4 * <br> --- | 1, 2 | |
| A | DE-U-1916383 (ALOYS MENNEKES) <br> * Seite 2, Absatz 3 - Seite 3, letzter Absatz; Figuren 1, 2 * <br> --- | 1, 3 | |
| A | EP-A-0157285 (CEAG LICHT-UND STROMVERSORGUNGSTECHNIK) <br> * Zusammenfassung; Figur 1 * <br> ----- | 1 | |

RECHERCHIERTE SACHGEBIETE (Int. Cl.4)

H02B
H05K
H01B

Der vorliegende Recherchenbericht wurde für alle Patentansprüche erstellt

| Recherchenort | Abschlußdatum der Recherche | Prüfer |
|---|---|---|
| DEN HAAG | 08 MAI 1989 | WOODALL C.G. |